# EUROPÄISCHE PATENTSCHRIFT

(11) **EP 2 637 028 B1**
(45) Veröffentlichungstag und Bekanntmachung des Hinweises auf die Patenterteilung: **07.09.2016**
(21) Anmeldenummer: 12158089.8
(22) Anmeldetag: 05.03.2012
(51) Int. Cl.: G01R 27/02, G01R 27/18, G01R 31/00, G01R 31/02, G01R 31/36

(54) **Vorrichtung und Verfahren zum Prüfen von Hochvoltbatterien**
Assembly and device for testing high voltage batteries
Dispositif et procédé destinés à la vérification de batteries à haute tension

(43) Veröffentlichungstag der Anmeldung: 11.09.2013
(73) Patentinhaber: Solin GmbH, 82024 Taufkirchen (DE)
(72) Erfinder: Marquardt, Rainer, 82041 Oberhaching (DE); Vogel, Tobias, 80797 München (DE); Cuje, Michael, 81543 München (DE)
(74) Vertreter: Vossius & Partner Patentanwälte Rechtsanwälte mbB

(56) Entgegenhaltungen:
- EP-A2- 0 602 432
- WO-A1-2007/064110
- WO-A1-2011/050670
- DE-A1- 10 337 064
- DE-A1-102009 042 192
- DE-A1-102009 054 546
- DE-A1-102010 044 230
- US-A1- 2002 190 693
- US-A1- 2004 076 872
- US-A1- 2006 261 677
- US-B1- 6 268 710
- US-B2- 7 642 787
- E-H AGLZIM ET AL: "Impedance measurement of a fuel cell on load", ELECTRICAL POWER QUALITY AND UTILISATION, 2007. EPQU 2007. 9TH INTERNATIONAL CONFERENCE ON, IEEE, PISCATAWAY, NJ, USA, 9. Oktober 2007 (2007-10-09), Seiten 1-4, XP031226030, ISBN: 978-84-690-9441-9

## Beschreibung

Die vorliegende Erfindung betrifft eine Vorrichtung und ein Verfahren zum Prüfen, Konditionieren und Symmetrieren von Hochvoltbatterien. Eine so geprüfte Hochvoltbatterie kann beispielsweise anschließend in ein Elektrofahrzeug als Traktionsbatterie eingesetzt werden.

Elektrisch angetriebene Fahrzeuge benötigen sehr leistungsfähige, wiederaufladbare und transportable Stromquellen. Diese werden unter anderem aus vielen Einzelbatterien zusammengeschaltet und enthalten zunehmend eigene Elektronikkomponenten. Vor dem Einbau in ein Fahrzeug müssen die zusammengesetzten Systeme beim Hersteller der Traktionsbatterie und/oder beim Fahrzeughersteller geprüft werden. Dabei werden sowohl die Leistungsparameter als auch batterieinterne Eigenschaften wie z.B. Isolationswiderstände und Innenwiderstand gemessen. Im Allgemeinen wird zu diesem Zweck der Einsatzfall simuliert, in dem die Batterie an einem Verbraucher angeschlossen wird. Dieser Verbraucher kann ein Elektromotor sein, in der Praxis verwendet man aber bevorzugt rückspeisefähige Stromversorgungs-/Stromsenkeneinheiten, um eine Rückspeisung der entnommenen Batterieenergie in ein vorhandenes Stromnetz zu ermöglichen.

Es sind mehrere Verfahren zur Bestimmung des Innenwiderstandes einer Traktionsbatterie bekannt. Hierzu gehören die DE 10 2009 054 546A1, die DE 10 2010 044 230A1 und die DE 10 2009 042 192A1 zur Ermittlung des Innenwiderstands einer Traktionsbatterie.

Die US 7,642,787 B2 beschreibt ein System, das an ein Fahrzeug angeschlossen werden kann, um dann während der Fahrt Diagnosedaten zu sammeln, die dann wiederum Aufschluss über den Zustand der Batterie geben. Weiterhin werden intelligente Ladetechniken zur Verlängerung der Batterielebenszeit beschrieben.

Die WO 2007/064110 A1 beschreibt ein System, das dazu dient, die Batterie zu symmetrieren. Das bedeutet, es werden im ersten Schritt die Zustände aller einzelnen Zellen bestimmt. Dann werden im zweiten Schritt die Ladungszustände aller Zellen aneinander angepasst. Dies geschieht durch gezieltes Laden, bzw. Entladen der einzelnen Zellen. Gegenstand dieser WO-Veröffentlichung ist im Wesentlichen die Schaltungstopologie zum Verschalten der Ladequelle (bzw. des Entladewiderstandes) mit den Zellen.

Die WO 2011/050670 A1 beschreibt ein System, das den Innenwiderstand einer Batterie misst, wobei ein einstellbarer Widerstand in Reihe mit der Batterie geschaltet wird. Dieser wird solange automatisch justiert, bis der Spannungsabfall am Widerstand der gleiche ist, wie die Zellspannung der Batterie. Wenn dies erreicht ist, dann entspricht der Widerstandswert dem Innenwiderstand der Batterie.

Es ist eine Aufgabe der vorliegenden Erfindung, einen Prüfstand und ein Verfahren bereitzustellen, durch die relevante Messgrößen einer Hochvoltbatterie, insbesondere der Isolationswiderstand zwischen dem Hochvoltbatteriegehäuse und mindestens einer inneren Batteriezelle der Hochvoltbatterie gemessen und überprüft werden können.

Diese Aufgabe wird mit den Merkmalen der Patentansprüche gelöst.

Die Erfindung betrifft einen Prüfstand für Hochvoltbatterien gemaß Ansprunch 1 der eine rückspeisefähige Stromversorgungs-/Stromsenkeneinheit, ein Sicherheitssystem, ein Leitsystem, sowie eine Messschaltung in direktem Kontakt mit der Hochvoltbatterie mit mindestens einer Schaltkreisgruppe aufweist, wobei mindestens ein Schaltkreis der mindestens einen Schaltkreisgruppe zum Messen eines Isolationswiderstands zwischen einem Hochvoltbatteriegehäuse und mindestens einer inneren Batteriezelle der Hochvoltbatterie geeignet ist.

Die Hochvoltbatterie kann eine Batterie zum Betreiben von Elektro- oder Hybridfahrzeugen oder sonstigen Anwendungen, bei denen Energiespeicher mit hoher Kapazität und Leistungsfähigkeit erforderlich sind, sein. Typische Spannungsbereiche solcher Hochvoltbatterien sind mehrere hundert Volt, vorzugsweise 370V bis 400V. Erfindungsgemäß kann die Hochvoltbatterie aus mindestens einer inneren Batteriezelle bestehen. Die inneren Batteriezellen können beispielsweise Lithium-Ionen- oder Nickel-Metallhydrid-Batterien oder auch Doppelschichtkondensatoren, sogenannte Super Caps, sein. Eine Hochvoltbatterie kann ein integriertes Batteriemanagementsystem zur Steuerung der Lade- und Entladezyklen und deren Überwachung beinhalten. Des Weiteren kann das Batteriemanagementsystem interne Überwachungs- und Schutzmechanismen aufweisen, um eventuelle Beschädigungen oder Störungen der Hochvoltbatterie rechtzeitig zu detektieren.

Die rückspeisefähige Stromversorgungs-/Stromsenkeneinheit kann eine elektronisch geregelte Stromquelle und eine rückspeisende elektronische Last aufweisen, wobei der Übergang zwischen Netzspeisung und Netzrückspeisung kontinuierlich stattfinden kann. Des Weiteren kann die Stromversorgungs-/Stromsenkeneinheit von dem Stromnetz galvanisch getrennt sein und einen einstufigen oder mehrstufigen Ausgangsfilter aufweisen.

Das Sicherheitssystem kann erfindungsgemäß durch eine speicherprogrammierbare Steuerung gesteuert werden. Das Sicherheitssystem hat erfindungsgemäß Zugriff auf andere Bauteile des Prüfstandes, wie z.B. die rückspeisefähige Stromversorgungs-/Stromsenkeneinheit, so dass gegebenenfalls das Sicherheitssystem diese abschalten kann. Des Weiteren kann das Sicherheitssystem auf verschiedene Schütze zugreifen, um den Testbetrieb sofort zu unterbrechen und einen gesicherten Zustand herstellen zu können. Erfindungsgemäß verfügt das Sicherheitssystem über Mittel zur Strom- und Spannungsmessung auf den Hochvoltleitungen des Prüfstandes.

Das Leitsystem kann erfindungsgemäß Komponenten zur Ablaufsteuerung der Prüfungen der Hochvoltbatterie aufweisen, inklusive einer Testautomatisierungsfunktion. Teil der Testautomatisierungsfunktion kann eine Routine zum automatisierten Ablauf der erforderlichen Testfälle, ein automatisches Erzeugen von weiterverwertbaren Testergebnissen, sowie eine Controller-Area-Network- (CAN) Restbussimaltion sein. Des Weiteren weist das Leitsystem erfindungsgemäß Mittel zur Ansteuerung der rückspeisefähigen Stromversorgungs-/Stromsenkeneinheit, sowie ein Messwerterfassungssystem zur Datenerfassung der von dem Messschaltkreis generierten Messwerte auf. Das Leitsystem kann sich erfindungsgemäß mit dem Sicherheitssystem in Kontakt befinden, so dass Befehle zur Steuerung der einzelnen Testabläufe zuerst von dem Sicherheitssystem geprüft werden kann.

Die Messschaltung kann erfindungsgemäß aus mehreren einzelnen, separaten oder in Kontakt stehenden Schaltkreisen bestehen. Messschaltkreise können beispielsweise zur Messung der Hochvoltbatteriespannung, des Pulsleistungsprofil oder der Überlastschwelle der Batterie verwendet werden. Der Schaltkreis zum Messen des Isolationswiderstandes kann gemäß einer Ausführungsform von der rückspeisefähigen Stromversorgungs-/Stromsenkeneinheit und / oder dem Schutzleiter des Prüfstandes galvanisch getrennt sein, vorzugsweise durch einen Trennverstärker. Ein Trennverstärker trennt den Schaltkreis galvanisch von dem Schutzleiter durch beispielsweise eine Doppelspule (induktive Kopplung), einen Kondensator (kapazitive Kopplung) oder einen Optokoppler.

In einer Ausführungsform ist die Masse (das Bezugspotential) der Hochvoltbatterie während des Prüfbetriebs von dem Schutzleiter des Prüfstandes getrennt.

In einer weiteren Ausführungsform ist / sind das Sicherheitssystem und / oder das Leitsystem von der Messschaltung galvanisch getrennt.

In einer Ausführungsform ist / sind die Messschaltung und /oder mindestens ein Schaltkreis von der rückspeisefähigen Stromversorgungs-/Stromsenkeneinheit galvanisch getrennt.

In einer weiteren Ausführungsform ist / sind das Sicherheitssystem und / oder das Leitsystem mit dem Schutzleiter direkt kontaktiert.

In einer Ausführungsform weist der Schaltkreis, der zum Messen des Isolationswiderstands zwischen dem Hochvoltbatteriegehäuse und der mindestens einen inneren Batteriezelle der Hochvoltbatterie geeignet ist, mindestens einen Messverstärker auf, der von dem Schutzleiter durch einen Trennverstärker isoliert ist.

In einer weiteren Ausführungsform weist der Schaltkreis, der zum Messen des Isolationswiderstands zwischen dem Hochvoltbatteriegehäuse und der mindestens einen inneren Batteriezelle der Hochvoltbatterie geeignet ist, mehrere Widerstandsmessbereiche auf, wobei die Messbereiche automatisch durch mindestens einen Messbereichsumschalter umschaltbar sind. Der mindestens eine Messbereichsumschalter wird vorzugsweise durch das Leitsystem gesteuert.

In einer Ausführungsform weist der Schaltkreis, der zum Messen des Isolationswiderstands zwischen dem Hochvoltbatteriegehäuse und der mindestens einen inneren Batteriezelle der Hochvoltbatterie geeignet ist, mindestens eine Klemmschaltung, vorzugsweise mit mindestens einem Widerstand und mindestens einem Zener-Dioden-Paar, auf. Eine solche Klemmschaltung kann im Falle eines Kurzschlusses die Messschaltung und ihre einzelnen Bauteile schützen. Das Zener-Dioden-Paar ist erfindungsgemäß so verschaltet, dass ihre Durchlassrichtungen entgegengesetzt sind.

In einer weiteren Ausführungsform weist das Sicherheitssystem mindestens einen Schütz zum Schalten mindestens eines Zwischenkreiskondensators auf, wobei der mindestens eine Schütz vorzugsweise mit mindestens einem Spiegelkontakt geschaltet wird. Ein solcher Zwischenkreiskondensator kann in dem Prüfstand entstehende Spannungsschwankungen kompensieren.

Die Erfindung betrifft auch ein Verfahren gemäß Ansprunch 12 zum Prüfen, Konditionieren und Symmetrieren einer Hochvoltbatterie, vorzugsweise in einem Prüfstand nach einem der vorangegangenen Ansprüche, das in folgender Reihenfolge folgende Schritte aufweist: Messen einer Batteriespannung, Überprüfung der Funktionsfähigkeit mindestens eines Relais, Überprüfung mindestens einer elektrischen Schaltsperre, Überprüfung mindestens eines Isolationswächters, Messen der Spannungsfestigkeit zwischen einem Pol der Hochvoltbatterie und dem Gehäuse der Hochvoltbatterie, Messen des Isolationswiderstandes zwischen einem Hochvoltbatteriegehäuse und mindestens einer inneren Batteriezelle der Hochvoltbatterie, Messen der Überlastschwelle, Veranschlagung der Hochvoltbatterie mit einem Stromprofil, Konditionierung der Hochvoltbatterie, und Symmetrieren der Hochvoltbatterie.

Das Messen der Funktionsfähigkeit eines Relais kann auch einen sogenannten "Relaisklebertest" beinhalten, bei dem überprüft werden kann, ob das Relais bei entsprechender Ansteuerung ordnungsgemäß auslöst oder nicht.

Erfindungsgemäß kann es sich bei dem zu testenden Isolationswächter um ein in der Hochvoltbatterie integriertes Bauteil handeln, das den Isolationszustand der Hochvoltbatterie und des an sie angeschlossenen Netzes überwacht und im Störungsfall in der Lage ist ein entsprechendes Signal an das Sicherheitssystem zu übertragen und / oder selbsttätig das gesamte System in einen sicheren Zustand zu überführen.

In einer weiteren Ausführungsform wird der Innenwiderstand mindestens einer inneren Batteriezelle der Hochvoltbatterie und / oder mindestens einer inneren Batteriezelle der Hochvoltbatterie gemessen.

In einer Ausführungsform wird die Kapazität der Hochvoltbatterie und / oder mindestens einer inneren Batteriezelle der Hochvoltbatterie gemessen.

In einer weiteren Ausführungsform wird die Leistung der Hochvoltbatterie und / oder mindestens einer inneren Batteriezelle der Hochvoltbatterie gemessen.

In einer Ausführungsform ist der Prüfstand für Hochvoltbatterien in einen Prüfplatz, z.B. in einer Konstruktionshalle, integriert. Der Prüfstand, insbesondere ein Sicherheitsbereich eines Prüfstandes wird erfindungsgemäß nach einem Sicherheits-Integrationslevel, vorzugsweise der Stufe 3, vor unbefugtem Zutritt während der Prüfphase gesichert werden. Dies kann z.B. durch Sicherheitszäune, elektrisch gesicherte Türschlösser oder Laserscanner realisiert werden.

Auch betrifft die Erfindung einen Prüfstand für Hochvoltbatterien, der eine rückspeisefähige Stromversorgungs-/Stromsenkeneinheit, ein Sicherheitssystem, mindestens zwei Leitsysteme, sowie mindestens zwei Messschaltungen in direktem Kontakt mit der Hochvoltbatterie mit jeweils mindestens einem Schaltkreis aufweist, wobei mindestens ein Schaltkreis des mindestens jeweils einen Schaltkreises zum Messen eines Isolationswiderstands zwischen einem Hochvoltbatteriegehäuse und mindestens einer inneren Batteriezelle der Hochvoltbatterie geeignet ist.

Die Erfindung wird nachstehend mit Bezug auf die anliegende Zeichnung näher erläutert:
Figur 1 zeigt ein Schaltbild eines Prüfstandes für Hochvoltbatterien gemäß einer Ausführungsform.
Figur 2 zeigt eine Ausführungsform eines Schaltbildes eines Messschaltkreises zur Messung des Isolationswiderstandes zwischen dem Gehäuse der Hochvoltbatterie und mindestens einer inneren Batteriezelle der Hochvoltbatterie.
Figur 3a zeigt exemplarisch Werte für in einem Messschaltkreis zur Messung des Isolationswiderstandes zwischen dem Gehäuse der Hochvoltbatterie und mindestens einer inneren Batteriezelle der Hochvoltbatterie verwendete Bauteile gemäß einer Ausführungsform.
Figur 3b zeigt eine exemplarische Ausgangsspannung eines Messschaltkreises zur Messung des Isolationswiderstandes zwischen dem Gehäuse der Hochvoltbatterie und mindestens einer inneren Batteriezelle der Hochvoltbatterie in Abhängigkeit verschiedener Messbereiche gemäß einer Ausführungsform.
Figur 4 zeigt ein Beispiel eines hierarchisch strukturierten Verfahrens zum Prüfen und zur Konditionierung einer Hochvoltbatterie gemäß einer Ausführungsform.
Figur 5 zeigt eine exemplarische Ausführungsform eines Prüfplatzes mit vorhandenem Prüfstand für Hochvoltbatterien gemäß einer Ausführungsform.
Figur 6 zeigt ein Schaltbild eines Prüfstandes für Hochvoltbatterien gemäß einer Ausführungsform.

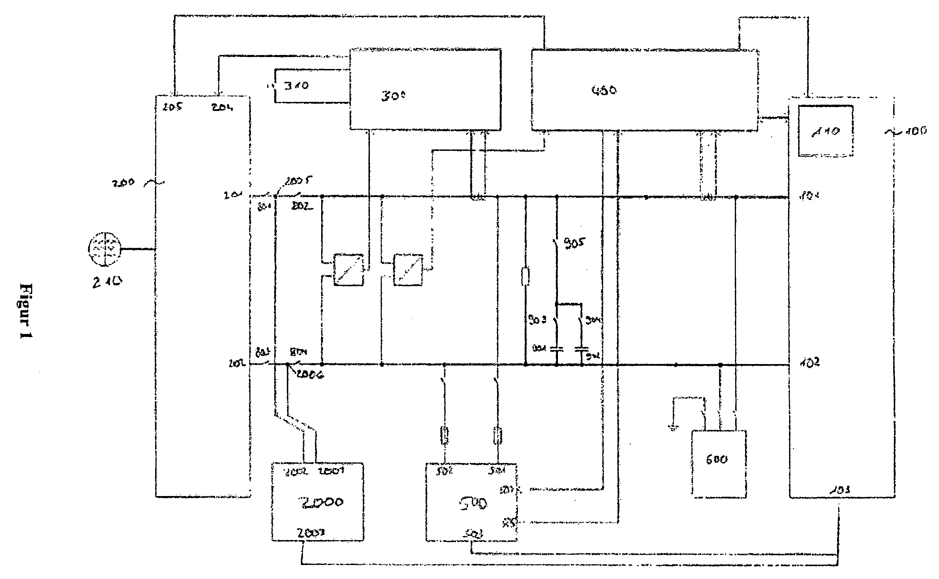

In Figur 1 wird beispielhaft ein Schaltbild eines Prüfstandes für Hochvoltbatterien gezeigt. Eine Hochvoltbatterie 100 mit einem Pluspol 101, einem Minuspol 102, einer Masse 103 und einem Batteriemanagementsystem (BMS) 110 ist mit einer rückspeisefähigen Stromversorgungs-/Stromsenkeneinheit 200 mit entsprechendem Pluspol 201 und entsprechendem Minuspol 202 verschaltet. Die rückspeisefähige Stromversorgungs-/Stromsenkeneinheit 200 besitzt ferner eine Netzanbindung 210. Des Weiteren weist das Schaltbild des Prüfstandes ein Sicherheitssystem 300, ein Leitsystem 400, eine Messschaltung 500, sowie einen externen Isolationswächter 600 auf. Die Messschaltung 500 weist Eingänge für den Pluspol 501 und den Minuspol 502, einen Eingang 503 für die Masse der Hochvoltbatterie 103, sowie einen Eingang zur Relaissteuerung 504 und einen Ausgang zur Ausgabe der Messgrößen 505 auf. Das Sicherheitssystem ist über einen U/I - Verstärker 701 von der Verbindung zwischen der Hochvoltbatterie 100 und der rückspeisefähigen Stromversorgungs-/Stromsenkeneinheit 200 und von der Messschaltung 500 galvanisch getrennt.

Mit dem Sicherheitssystem 300 ist eine Notausvorrichtung 310 verbunden. Gemäß einer Ausführungsform können vier Schütze mit Spiegelkontakten 801-804 von dem Sicherheitssystem geschaltet werden. Auch hat das Sicherheitssystem über den Anschluss 204 eine direkte Steuermöglichkeit der rückspeisefähigen Stromversorgungs-/Stromsenkeneinheit 200. Das Sicherheitssystem 300 hat die Möglichkeit die Zellspannung der Hochvoltbatterie 100 und den Strom direkt zu messen und zu überwachen. Wird die Notausvorrichtung 310 betätigt oder findet ein sonstiger Notfall statt, kann das Sicherheitssystem durch Schalten der vier Schütze 801-804, der rückspeisefähigen Stromversorgungs-/Stromsenkeneinheit 200 und durch Erden der Masse 103 der Hochvoltbatterie 100 den Prüfstand sofort in einen sicheren Zustand überführen. Das Sicherheitssystem 200 kann gemäß einer Ausführungsform jeweils einen von zwei Zwischenschaltkreiskondensatoren 901 bzw. 902 für den Testbetrieb durch zwei dementsprechende Schütze 903 bzw. 904 auswählen. Gemäß einer Ausführungsform kann vor die Zwischenschaltkreiskondensatoren 901 bzw. 902 und die Schütze 903 bzw. 904 ein weiterer Schütz 905 geschaltet werden.

Das Leitsystem 400 stellt die Ablaufsteuerung inklusive der Testautomatisierungsfunktion zur Verfügung und ist mit einem Mess- und Steuersystem ausgestattet. Die Testautomatisierungsfunktion kann eine Routine zum automatisierten Ablauf der erforderlichen Testsfälle, ein automatisches Erzeugen von weiterverwertbaren Testergebnissen, Logbuch-Dateien, eine Controller-Area-Network- (CAN) Restbussimaltion, die Diagnose und das Programmieren der BMS 110 und das Einlesen eines Data-Matrix-Code der Hochvoltbatterie 100 aufweisen. Des Weiteren kann das Leitsystem 400 an eine Datenbank und einen Etikettendrucker angebunden werden (beide nicht eingezeichnet). Eine weitere erfindungsgemäße Aufgabe des Leitsystems 400 ist die Ansteuerung der rückspeisefähigen Stromversorgungs-/Stromsenkeneinheit 200 über den Eingang 205 und die Ansteuerung sich in der Messschaltung 500 befindlicher Relais durch den Eingang für die Relaissteuerung 501. Das Messen von in der Messschaltung 500 auftretenden Messspannungen und Messströmen und eine anschließende Report-Generierung ist ebenfalls eine erfindungsgemäße Aufgabe des Leitsystems 400. Gemäß einer Ausführungsform der vorliegenden Erfindung sendet das Leitsystem 400 vor der eigentlichen Ausführung einer Anforderung, beispielsweise einer Messanforderung innerhalb einer automatisierten Testroutine, diese Anforderung an das Sicherheitssystem 300. Das Sicherheitssystem 300 prüft die Anforderung unter Einbezug des aktuellen Gesamtstatus auf Sicherheitskonflikte und bei bestandener Prüfung wird die Aktion ausgeführt; so kann beispielsweise ein Relais innerhalb der Messschaltung 500 gesetzt werden. Eine weitere erfindungsgemäße Aufgabe des Leitsystems 400 ist die Bereitstellung einer unabhängigen, von der Masse 103 isolierten Niedervoltversorgung des BMS 110.

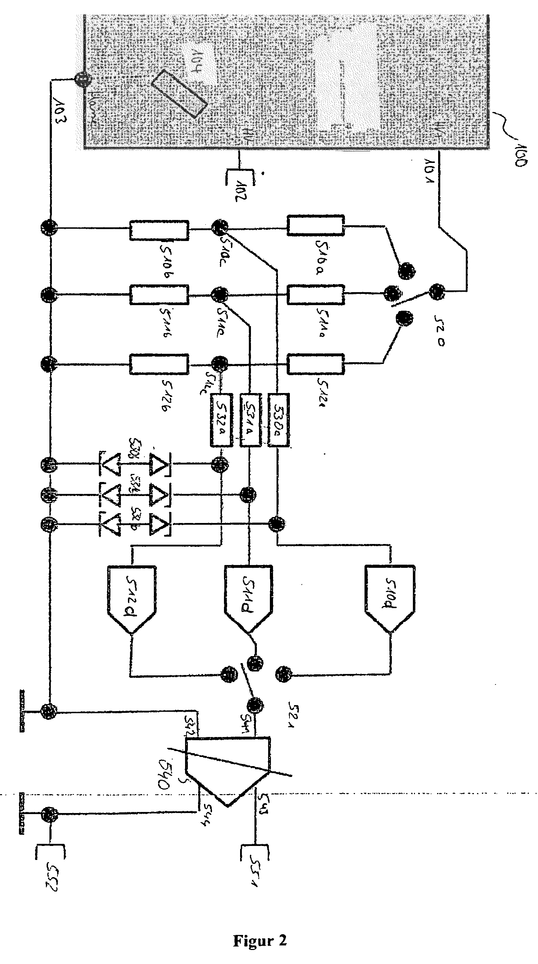

Die Messschaltung 500 kann erfindungsgemäß mehrere Messschaltkreisgruppen für verschiedene Messabläufe und -größen aufweisen. Jede Messschaltkreisgruppe kann einen oder mehrere Messschaltkreise aufweisen. Ein Messschaltkreis kann durch sukzessives Auflegen von Widerständen zur Provozierung von Isolationsfehlern der Batterie und der Bestimmung der Größenordnung des Isolationsfehlers verwendet werden. Auf diese Weise kann die Funktionstüchtigkeit eines in dem BMS 110 befindlichen Isolationswächters überprüft werden. Auch können weitere Messschaltkreise dazu verwendet werden, die Gesamtspannung, die einzelnen Zellspannungen und andere relevante Parameter der Hochvoltbatterie zu messen. Gemäß einer Ausführungsform weist die Messschaltung 500 ebenfalls einen Messschaltkreis zur Bestimmung des Isolationswiderstandes 104 (siehe Figur 2) zwischen dem Gehäuse der Hochvoltbatterie 100 und mindestens einer inneren Batteriezelle der Hochvoltbatterie 100 (beides nicht eingezeichnet) auf. Ein Ausführungsbeispiel eines solchen Messschaltkreises zur Bestimmung des Isolationswiderstandes wird detailliert weiter unten beschrieben.

Eine weitererer Messschaltkreis 2000 kann erfindungsgemäß der Überprüfung der Hochvoltfestigkeit der Hochvoltbatterie 100 dienen. Dieser Messschaltkreis 2000 kann erfindungsgemäß sowohl mit dem Gehäuse eines Hochvoltspeichers 103 verbunden sein, als auch mit zwei Abgriffen 2005 und 2006, die sich jeweils zwischen den Hauptschützen 801 und 802, bzw. zwischen den Hauptschützen 803 und 804 befinden.

Der externe Isolationswächter 600 kann erfindungsgemäß Isolationsfehler an dem Prüfstand während eines Bereitschaftszustandes, d.h. in dem Zustand in dem noch keine Messung stattfindet, sowie bei einem Wechsel von einer Hochvoltbatterie 100 zur nächsten feststellen und einen entsprechenden Hinweis an das Sicherheitssystem 300 leiten, so dass gegebenenfalls ein sicherer Zustand hergestellt werden kann.

Figur 2 zeigt eine Ausführungsform eines Schaltbildes eines Messschaltkreises zur Messung des Isolationswiderstandes 104 zwischen dem Gehäuse der Hochvoltbatterie 100 und mindestens einer inneren Batteriezelle der Hochvoltbatterie 100. Der Pluspol 101 der Hochvoltbatterie 100 ist mit einem von dem Leitsystem 400 zu schaltenden Messbereichsumschalter 520 verbunden, Der Minuspol 102 ist nicht kontaktiert, die Masse 103 der Batterie ist mit einem Eingang 542 eines Trennverstärkers 540 kontaktiert, der den kompletten Messschaltkreis zur Messung des Isolationswiderstandes 104 von dem Schutzleiter (Protective Earth PE) des restlichen Prüfstandes isoliert.

Mit dem Messbereichsumschalter 520 sind drei parallel angeordnete Widerstandsbänke mit jeweils zwei in Reihe geschalteten Widerständen 510a und 510b bzw. 511a und 511b bzw. 512a und 512b verschaltet. Die Widerstandsbänke sind auf der anderen Seite mit der Masse 103 kontaktiert. Zwischen den jeweils zwei Widerständen 510a und 510b bzw. 511a und 511b bzw. 512a und 512b befindet sich jeweils ein Knotenpunkt 510c bzw. 511c bzw. 512c, der zu jeweils einem Messbereichsverstärker 510d bzw. 511d bzw. 512d führt. Die jeweils zwei Widerstände zusammen mit dem jeweils entsprechenden Messbereichsverstärker bilden einen Messbereich, so dass sich in dem Messschaltkreis gemäß Ausführungsform insgesamt drei Widerstandsmessbereiche befinden. Gemäß einer weiteren Ausführungsform kann die Anzahl der Widerstandsmessbereiche entsprechend erhöht werden. Zwischen den Knotenpunkten 510c bzw. 511c bzw. 512c und den Messbereichsverstärkern 510d bzw. 511d bzw. 512d kann sich jeweils eine Klemmschaltung befinden, die jeweils einen Widerstand 530a bzw. 531a bzw. 532a und ein Paar entgegengesetzt angeordneter Zener-Dioden 530b bzw. 531b bzw. 532b aufweist. Solche Klemmschaltungen dienen als Schutzschaltungen zum Schutz der Messbereichsverstärker 510d bzw. 511d bzw. 512d im Falle eines Kurzschlusses zwischen dem Pol 102 der Batterie 100 und dem Gehäuse der Batterie 100. Die Messbereichsverstärker 510d bzw. 511d bzw. 512d sind über einen zweiten ebenfalls von dem Leitsystem 400 zu schaltenden Messbereichsumschalter 521 mit einem zweiten Eingang 541 des Trennverstärkers 540 verbunden. Der so konzipierte Messschaltkreis zeigt in Bezug auf den Schutzleiter (PE) eine Hochvoltfestigkeit in der Größenordnung von mehreren Kilovolt auf, abhängig von potenziellen Prüfspannungen, die in den jeweiligen Testroutinen angewendet werden. Durch eine Nullstellung der Messbereichsumschalter 520 und 521 kann der komplette Messschaltkreis zur Messung des Isolationswiderstandes 104 von der zu prüfenden Hochvoltbatterie 100 bei Nichtbenutzung des Schaltkreises getrennt werden.

Der Trennverstärker ist auf der anderen Seite mit den Anschlüssen 543 bzw. 544 mit den Messausgängen 551 bzw. 552 verbunden, so dass die zu messenden Spannungen Uₐᵤₛ zwischen 551 und 552 über den Anschluss 503 der Messschaltung 500 durch das Leitsystem 400 gemessen werden können.

Die Wahl der Größe der Widerstände 510a und 510b bzw. 511 a und 511b bzw. 512a und 512b findet erfindungsgemäß aufgrund folgender Randbedingungen statt: Der Gesamtwiderstand R_{ges} = R₅₁₀ₐ + R_{510b} + R₅₁₁ₐ + R_{511b} + R₅₁₂ₐ + R_{512b} darf einen bestimmten Wert nicht übersteigen, da sonst die Messzeit verlängert werden würde, da sich parasitäre Ladungen umladen müssten. Des Weiteren darf der Gesamtwiderstand R_{ges} nicht zu klein sein, da die resultierenden Messspannungen zu klein sein würden und somit das Signal-zu-Rausch-Verhältnis des Messbereichsverstärkers 510d bzw. 511d bzw. 512d zu klein sein würde. Eine weitere Randbedingung ergibt sich aus dem Spannungsteilerverhältnis R_{510b}/R₅₁₀ₐ + R_{510b}) bzw. R_{510b}/(R₅₁₁ₐ + R_{511b}) bzw. R_{512b}/(R₅₁₂ₐ + R_{512b}), das nicht zu klein werden darf, da in diesem Fall ebenfalls das Signal-zu-Rausch-Verhältnis zu klein werden würde. Das Spannungsteilerverhältnis R_{510b}/(R₅₁₀ₐ + R_{510b}) bzw. R_{511b}/(R₅₁₁ₐ + R_{511b}) bzw. R_{512b}/(R₅₁₂ₐ + R_{512b}) darf allerdings auch einen gewissen Wert nicht überschreiten, da sonst im Falle eines Kurzschlusses zwischen dem Pol 101 der Batterie 100 und dem Gehäuse der Batterie 100 der Ableitungsstrom in der entsprechenden Klemmschaltung zu groß werden und diese zerstören würde.

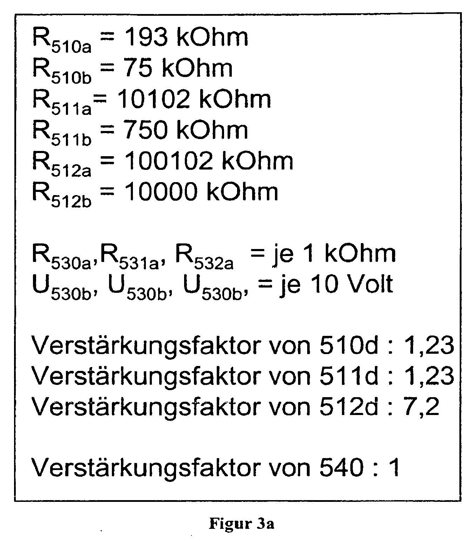

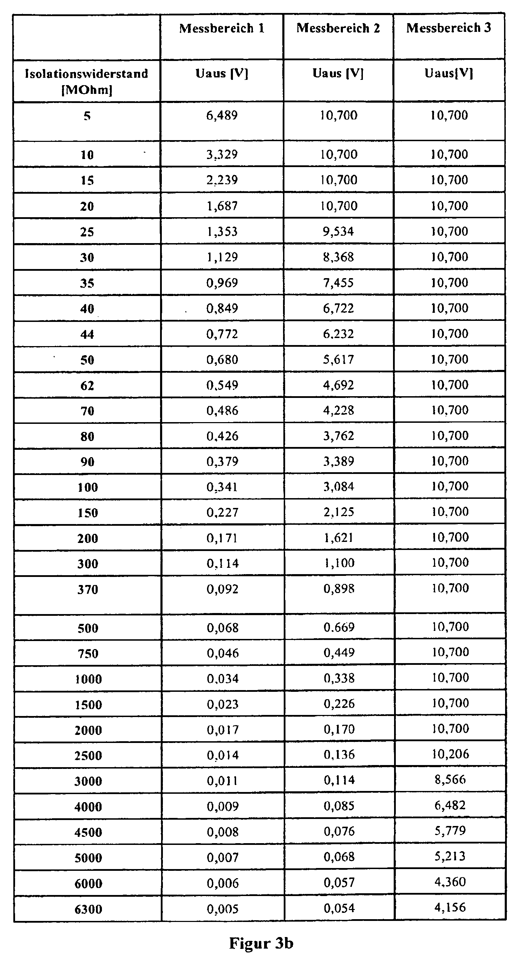

Beispielhaft zeigt Figur 3a Werte für die Widerstände 510a u, 510b, 511a, 511b, 512a, 512b, 530a, 531a und 532a und für die Zener-Diodenpaare 530b, 531b und 532b der Klemmschaltung, sowie für die Verstärkungsfaktoren der Messbereichsverstärker 510d, 511d, 512d und des Trennverstärkers 540. Die Werte können mit Hilfe elektrotechnischer Grundlagen, unter anderem der Kirchhoffschen Regeln, bestimmt werden. Figur 3b zeigt unter der exemplarischen Annahme einer Batteriespannung von 370 V und der obigen exemplarischen Werte eine Ausgangsspannung Uₐᵤₛ für den jeweiligen Messbereich in Abhängigkeit von dem Isolationswiderstand 104. Messbereich 1 beinhaltet die Widerstandsbank mit den Widerständen 510a und 510b, Messbereich 2 die Widerstandsbank mit 511a und 511b und Messbereich 3 die Widerstandsbank mit 512a und 512b. Wie den Werten für die Ausgangsspannung für den jeweiligen Messbereich in Abhängigkeit von dem Isolationswiderstand 104 zu entnehmen ist, ist der Messbereich 1 für die Messung von Isolationswiderständen 104, die einen Wert von 5 bis 300 MOhm annehmen am besten geeignet, da in diesem Bereich die Ausgangsspannung Uₐᵤₛ Werte aufweist, die mit einem Messgerät problemlos messbar sind. Messbereich 2 übersteuert in einem Bereich bis einschließlich 20 MOhm des Isolationswiderstandes und ist ab 25 MOhm bis einschließlich 3 GOhm des Isolationswiderstandes geeignet. Messbereich 3 übersteuert bis einschließlich 2,5 GOhm des Isolationswiderstandes und ist daher ab 3,5 GOhm des Isolationswiderstandes geeignet.

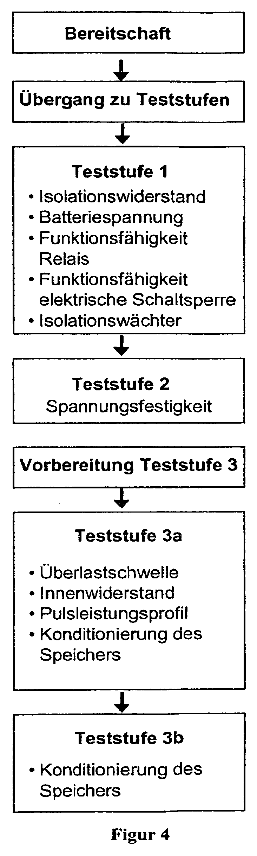

Figur 4 zeigt ein exemplarisches Beispiel eines hierarchisch strukturierten Verfahrens zum Prüfen und zur Konditionierung einer Hochvoltbatterie 100 gemäß einer Ausführungsform. In einem ersten Schritt, dem Bereitschaftszustand, ist der Prüfstand komplett inaktiv und in einem gesicherten Zustand, in dem beispielsweise eine bereits geprüfte Hochvoltbatterie 100 von einer Fachkraft abgeklemmt und durch eine noch zu prüfende Hochvoltbatterie 100 ersetzt werden kann.

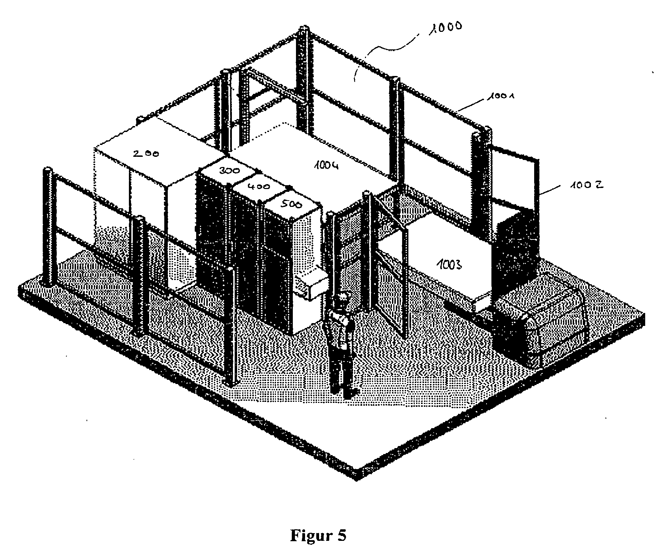

In einem zweiten Schritt befindet sich der Prüfstand in einer Übergangsphase zum anschließenden Testbetrieb. In diesem zweiten Schritt ist die Hochvoltbatterie an den Prüfstand angeschlossen und alle Fachkräfte befinden außerhalb eines definierten Sicherheitsbereichs 1000 (siehe Figur 5).

In einem dritten Schritt befindet sich der Prüfstand in der sogenannten Teststufe 1, bei der ein entsprechender Messschaltkreis bereits mit der Hochvoltbatterie 100 verbunden ist, nicht jedoch mit der rückspeisefähigen Stromversorgungs-/Stromsenkeneinheit 200. In dieser Teststufe 1 können beispielsweise die Batteriespannung, die Funktionstüchtigkeit von eventuell vorhandenen Relais ("Relaisklebertests"), die Funktionstüchtigkeit von eventuell vorhandenen elektrischen Schaltsperren ("Interlocktests"), Isolationswiderstand 104 zwischen dem Gehäuse der Hochvoltbatterie 100 und mindestens einer inneren Batteriezelle der Hochvoltbatterie 100 bestimmt werden , sowie die Funktionstüchtigkeit interner, in der Hochvoltbatterie 100 vorhandener, Isolationswächter überprüft werden.

In einer nächsten Teststufe, der Teststufe 2, kann mittels eines geeigneten Messschaltkreises die Spannungsfestigkeit der Hochvoltbatterie 100 getestet werden. Der Systemzustand des Prüfstandes ist in diesem Fall der gleiche wie bei Teststufe 1, mit der Ausnahme, daß die Hauptschütze 802 und 804 geschlossen sind, um einen weiteren Messschaltkreis 2000 zur Messung der Spannungsfestigkeit zuzuschalten. Dieser Messschaltkreis 2000 kann erfindungsmemäß sowohl mit dem Gehäuse eines Hochvoltspeichers 103 verbunden sein, als auch mit zwei Abgriffen 2005 und 2006, die sich jeweils zwischen den Hauptschützen 801 und 802, bzw. zwischen den Hauptschützen 803 und 804 befinden. Damit ist der entsprechende Messschaltkreis 2000 mit der Hochvoltbatterie 100 verbunden, nicht jedoch mit der rückspeisefähigen Stromversorgungs-/Stromsenkeneinheit 200.

In einem weiteren Schritt, dem Vorbereitungszustand für die Teststufe 3, ist die Messschaltung mit der Hochvoltbatterie 100 verbunden, während die rückspeisefähige Stromversorgungs-/Stromsenkeneinheit 200 für den Betrieb vorbereitet wird, jedoch noch nicht aktiviert ist.

In der anschließenden Teststufe 3a kann mittels entsprechender Messschaltkreise der, die Überlastschwelle der Hochvoltbatterie 100, das Pulsleistungsprofil der Hochvoltbatterie 100 und der Innenwiderstand der Hochvoltbatterie 100 bestimmt werden. Anschließend beginnt in dieser Teststufe die Konditionierung der Hochvoltbatterie 100 beispielsweise durch gezielte Lade- und Entladezyklen. Die darauffolgende Teststufe 3b hat denselben Systemzustand wie Teststufe 3a. In diesem Schritt wird die Hochvoltbatterie 100 weiter konditioniert.

Ein besonderer Vorteil einer solchen erfindungsgemäßen Testabfolge liegt in einer hohen Sicherheit des Prüfstandes sowohl für die zu prüfende Hochvoltbatterie 100, für die Bauteile des Prüfstandes als auch für den Benutzer. Die verschiedenen Teststufen 1,2, und 3 haben ein gemäß ihres oben beschriebenen Systemzustandes ansteigendes Gefahrenpotenzial.

Bricht eine Teststufe aufgrund von Nichtbestehen des Prüflings ab, werden dementsprechend die weiteren Teststufen, die ein höheres Gefahrenpotenzial besitzen, nicht mehr ausgeführt.

Figur 5 zeigt eine exemplarische Ausführungsform eines Prüfplatzes mit vorhandenem Prüfstand für Hochvoltbatterien gemäß einer Ausführungsform der Erfindung. Der Sicherheitsbereich 1000 des Prüfstandes, in dem die Messungen stattfinden, wird vorzugsweise nach dem Sicherheits-Integritätslevel (SIL) der Stufe 3 vor unbeabsichtigtem bzw. unbefugtem Zutritt während der Prüfphase gesichert. Dazu kann z.B. ein elektrisch überwachter Sicherheitszaun 1001, ein elektrisch gesichertes Türschloss 1002 und ein den Prüfstand sichernder Laserscanner (nicht eingezeichnet) integriert werden. Die rückspeisefähige Stromversorgungs-/Stromsenkeneinheit 200, das Sicherheitssystem 300, das Leitsystem 400 und die Messschaltung 500 können in nebeneinander stehenden Schaltschränken derart verbaut werden, dass sich Steuereinheiten, z.B. Eingabegeräte und Displays, nicht in dem Sicherheitsbereich 1000 befinden, sondern gefahrlos während einer Teststufe benutzt werden können. Befindet sich eine Person in dem Sicherheitsbereich 1000 oder versucht den Sicherheitsbereich 1000 zu betreten, löst ein Sicherheitsmerkmal, wie z.B. der Laserscanner, einen Alarm aus und leitet diesen an das Sicherheitssystem 300 weiter. Der Testbetrieb kann nicht starten oder wird sofort unterbrochen.

Vor und nach dem Testbetrieb kann die zu prüfende Hochvoltbatterie 100 von einer Fachkraft mit einem elektrischen Hubtisch 1003 auf den in dem Sicherheitsbereich 1000 befindlichen Arbeitstisch 1004 platziert werden, wo die Hochvoltbatterien 100 beispielsweise an die Messschaltung 500 angeschlossen werden kann.

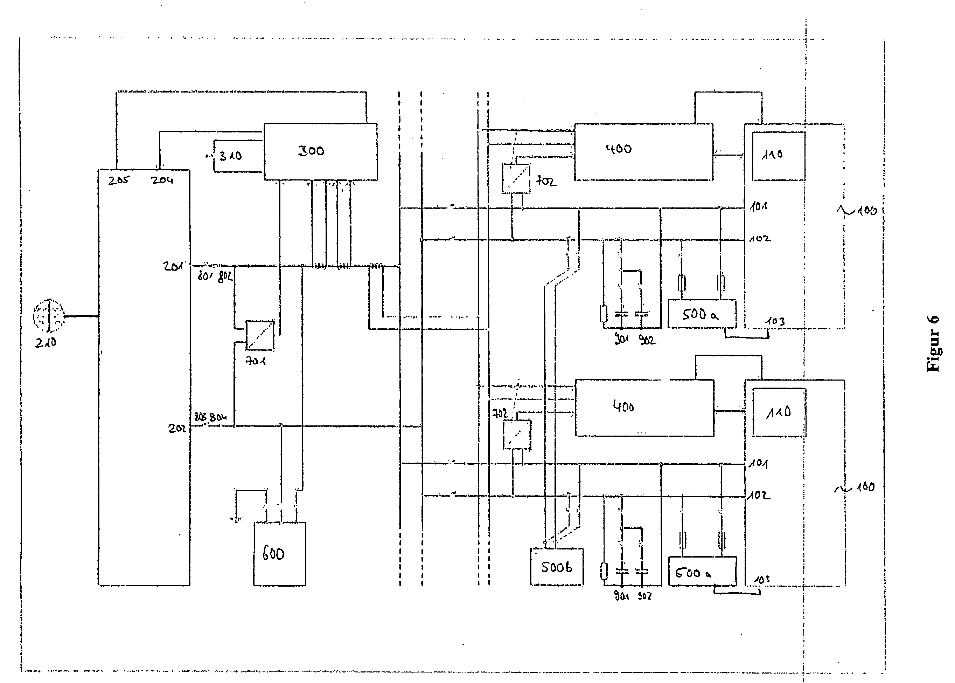

Figur 6 zeigt ein Schaltbild eines Prüfstandes gemäß einer Ausführungsform, bei dem mehrere Hochvoltbatterien 100 in jeweils einem eigenen Prüffeld gleichzeitig geprüft werden können. Erfindungsgemäß können einige Anlagenressourcen, wie z.B. das Sicherheitssystem 300, die rückspeisefähige Stromversorgungs-/Stromsenkeneinheit 200, der externe Isolationswächter 600, sowie einige in der Messschaltung 500b zusammengefasste Messschaltkreise von allen Prüffeldern gemeinsam benutzt werden. Andere Anlagenressourcen, wie beispielsweise das Leitsystem 400, die Zwischenkreiskondensatoren 901 und 902 oder einige in der Messschaltung 500a zusammengefasste Messschaltkreise sind in jedem einzelnem Prüffeld separat vorhanden.

## Patentansprüche

1. *Prüfstand für Hochvoltbatterien (100), der folgende Merkmale aufweist:*
*a) eine rückspeisefähige Stromversorgungs-*/*Stromsenkeneinheit (200);*
*b) eine Messschaltung. (500) in direktem Kontakt mit der Hochvoltbatterie (100) mit mindestens einer Messschaltkreisgruppe, wobei mindestens ein Messschaltkreis der mindestens einen Messschaltkreisgruppe dazu eingerichtet ist, einen Isolationswiderstand. (104) zwischen einem Hochvoltbatteriegehäuse (103) und mindestens einer inneren Batteriezelle der Hochvoltbatterie (100) zu messen;*
*c) einen Messschaltkreis (2000), der dazu eingerichtet ist, die Hochvoltfestigkeit der Hochvoltbatterie (100) zu überprüfen;*
*d) ein Sicherheitssystem (300), das dazu eingerichtet ist, die Zellspannung der Hochvoltbatterie und den Strom direkt zur messen und zu überwachen, und das den Prüfstand in einen sicheren Zustand überführen kann;*
*e) ein Leitsystem (400), das mit einem Mess- und Steuersystem ausgestattet ist, und das dazu eingerichtet ist, die Ablaufsteuerung inklusive der Testautomatisierungsfunktion zur Verfügung zu stellen, die rückspeisefähige Stromversorgungs-*/*Stromsenkeneinheit (200) anzusteuern, die in der Messschaltung (500) befindlichen Relais anzusteuern, die in der Messschaltung auftretenden Messspannungen und Messströme zu messen, Anforderungen an das Sicherheitssystem (300) zu senden sowie eine unabhängige, von der Masse (103) isolierte Niedervoltversorgung bereitzustellen; und*
*f*) *einen Isolationswächter (600), der dazu eingerichtet ist, Isolationsfehler an dem Prüfstand während eines Bereitschaftszustandes festzustellen und einen entsprechenden Hinweis an das Sicherheitssystem (300) zu leiten.*

2. Prüfstand nach Anspruch 1, wobei eine Masse (ein Bezugspotential) der Hochvoltbatterie (100) während des Prüfbetriebs von einem Schutzleiter des Prüfstandes getrennt ist.

3. Prüfstand nach Anspruch 1 oder 2, wobei das Sicherheitssystem (300) und / oder das Leitsystem (400) von der Messschaltung (500) galvanisch getrennt ist / sind.

4. Prüfstand nach einem der Ansprüche 1 bis 3, wobei die Messschaltung (500) und / oder mindestens ein Schaltkreis von der rückspeisefähigen Stromversorgungs-/Stromsenkeneinheit (200) galvanisch getrennt ist / sind.

5. Prüfstand nach einem der Ansprüche 2 bis 4, wobei das Sicherheitssystem (300) und / oder das Leitsystem (400) mit dem Schutzleiter direkt kontaktiert ist / sind.

6. Prüfstand nach einem der Ansprüche 2 bis 5, wobei der Messschaltkreis (2000) zum Messen des Isolationswiderstands (104) zwischen dem Hochvoltbatteriegehäuse (103) und der mindestens einen inneren Batteriezelle der Hochvoltbatterie (100) mindestens einen Messverstärker aufweist, der von dem Schutzleiter durch einen Trennverstärker isoliert ist.

7. Prüfstand nach einem der Ansprüche 1 bis 6, wobei der Messschaltkreis (2000) zum Messen des Isolationswiderstands (104) zwischen dem Hochvoltbatteriegehäuse (103) und der mindestens einen inneren Batteriezelle der Hochvoltbatterie (100) mehrere Widerstandsmessbereiche aufweist, wobei die Messbereiche automatisch durch mindestens einen Messbereichsumschalter umschaltbar sind.

8. Prüfstand nach einem der Ansprüche 1 bis 7, wobei der Messschaltkreis (2000) zum Messen des Isolationswiderstands (104) zwischen dem Hochvoltbatteriegehäuse (103) und der mindestens einen inneren Batteriezelle der Hochvoltbatterie (100) mindestens eine Klemmschaltung, vorzugsweise mit mindestens einem Widerstand und mindestens einem Zener-Dioden-Paar, aufweist.

9. Prüfstand nach einem der Ansprüche 1 bis 8, wobei das Sicherheitssystem (300) eine speicherprogrammierbare Steuerung aufweist.

10. Prüfstand nach einem der Ansprüche 1 bis 9, wobei das Sicherheitssystem (300) mindestens einen Schütz zum Schalten mindestens eines Zwischenkreiskondensators aufweist, wobei der mindestens eine Schütz vorzugsweise mit mindestens einem Spiegelkontakt geschaltet wird.

11. Prüfstand nach einem der Ansprüche 1 bis 10, wobei das Leitsystem (400) ein Messwerterfassungssystem zur Datenerfassung der von dem mindestens einem Messschaltkreis generierten Messwerte aufweist.

12. *Verfahren zum Prüfen und Konditionieren einer Hochvoltbatterie (100), in einem Prüfstand nach einem der vorangegangenen Ansprüche, das in folgender Reihenfolge folgende Schritte aufweist:*
*a) Messen des Isolationswiderstandes zwischen einem Hochvoltbatteriegehäuse (103) und mindestens einer inneren Batteriezelle der Hochvoltbatterie (100),*
*b) Messen einer Batteriespannung,*
*c) Überprüfung der Funktionsfähigkeit mindestens eines sich in der Messschaltung (500) befindlichen Relais,*
*d) Überprüfung mindestens einer elektrischen Schaltsperre,*
*e) Überprüfung mindestens eines Isolationswächters (110, 600),*
*f) Messen der Spannungsfestigkeit zwischen je einem Pol* (*101*, *102) der Hochvoltbatterie (100) und einem Gehäuse (103) der Hochvoltbatterie,*
*g) Messen der Überlastschwelle der Hochvoltbatterie (100),*
*h) Durchführen eines Pulsleistungsprofils der Hochvoltbatterie (100), und*
*i) Konditionierung der Hochvoltbatterie (100).*

13. Verfahren nach Anspruch 12, das ferner folgenden Schritt aufweist:
Messen des Innenwiderstandes mindestens einer inneren Batteriezelle der Hochvoltbatterie und / oder der Hochvoltbatterie.

14. Verfahren nach Anspruch 12 oder 13, das ferner folgenden Schritt aufweist:
Messen der Kapazität mindestens einer inneren Batteriezelle der Hochvoltbatterie und / oder der Hochvoltbatterie.

## Claims

1. A test stand for high voltage batteries (100) comprising the following features:
a) a power supply/power sink unit (200) which is capable of feeding back;
b) a measuring circuit (500) in direct contact with the high voltage battery (100) and comprising at least one measuring circuit group, wherein at least one measuring circuit of the at least one measuring circuit group is adapted to measure an insulation resistance (104) between a high voltage battery housing (103) and at least one inner battery cell of the high voltage battery (100);
c) a measuring circuit (2000) which is adapted to test the high voltage strength of the high voltage battery (100);
d) a safety system (300) which is adapted to directly measure and monitor the cell voltage of the high voltage battery and the current and which can transform the test stand into a safe state;
e) a control system (400) which comprises a measuring and controlling system and which is adapted to provide the sequence control including the test automation function, to control the power supply/power sink unit (200) which is capable of feeding back, to control the relays located in the measuring circuit (500), to measure the measuring voltages and measuring currents occurring in the measuring circuit, to send demands to the safety system (300) as well as to provide an independent low voltage supply insulated from the mass (103); and
f) an insulation monitor (600) which is adapted to detect insulation errors at the test stand during a standby state and to transmit a corresponding hint to the safety system (300).

2. The test stand according to claim 1, wherein a mass (a reference potential) of the high voltage battery (100) is separated from a protective conductor of the test stand during the test operation.

3. The test stand according to claim 1 or 2, wherein the safety system (300) and/or the control system (400) is/are galvanically separated from the measuring circuit (500).

4. The test stand according to any one of claims 1 to 3, wherein the measuring circuit (500) and/or at least one switching circuit is/are galvanically separated from the power supply/power sink unit (200) which is capable of feeding back.

5. The test stand according to any one of claims 2 to 4, wherein the safety system (300) and/or the control system (400) is/are in direct contact with the protective conductor.

6. The test stand according to any one of claims 2 to 5, wherein, for measuring the insulation resistance (104) between the high voltage battery housing (103) and the at least one inner battery cell of the high voltage battery (100), the measuring circuit (2000) comprises at least one measuring amplifier which is insulated relative to the protective conductor by an insulating amplifier.

7. The test stand according to any one of claims 1 to 6, wherein, for measuring the insulation resistance (104) between the high voltage battery housing (103) and the at least one inner battery cell of the high voltage battery (100), the measuring circuit (2000) comprises a plurality of resistance measuring ranges, wherein the measuring ranges are automatically shiftable by at least one measuring range changing device.

8. The test stand according to any one of claims 1 to 7, wherein, for measuring the insulation resistance (104) between the high voltage battery housing (103) and the at least one inner battery cell of the high voltage battery (100), the measuring circuit (2000) comprises at least one clamp circuit, preferably comprising at least one resistor and at least one pair of Zener diodes.

9. The test stand according to any one of claims 1 to 8, wherein the safety system (300) comprises a memory-programmable controller.

10. The test stand according to any one of claims 1 to 9, wherein the control system (300) comprises at least one contactor for shifting at least one intermediate circuit capacitor, wherein the at least one contactor is preferably shifted with at least one mirror contact.

11. The test stand according to any one of claims 1 to 10, wherein the control system (400) comprises a measuring value detecting system for detecting data of the measuring values generated by the at least one measuring circuit.

12. A method for testing and conditioning a high voltage battery (100) in a test stand according to any one of the preceding claims, which comprises the following steps in the following order:
a) measuring the insulation resistance between a high voltage battery housing (103) and at least one inner battery cell of the high voltage battery (100),
b) measuring a battery voltage,
c) checking the functional capability of at least one relay located in the measuring circuit (500),
d) checking at least one electrical shifting lock,
e) checking at least one insulation monitor (110, 600),
f) measuring the tension strength between a respective pole (101, 102) of the high voltage battery (100) and a housing (103) of the high voltage battery,
g) measuring the overload threshold of the high voltage battery (100),
h) carrying out a pulse power profile of the high voltage battery (100), and
i) conditioning the high voltage battery (100).

13. The method according to claim 12, further comprising the following step:
measuring the inner resistance of at least one inner battery cell of the high voltage battery and/or the high voltage battery.

14. The method according to claim 12 or 13, further comprising the following step:
measuring the capacity of at least one inner battery cell of the high voltage battery and/or the high voltage battery.

## Revendications

1. Banc d'essai pour batteries à haute tension (100), présentant les caractéristiques suivantes :
a) une unité bidirectionnelle d'alimentation en courant/puits de courant (200) ;
b) un montage de mesure (500) en contact direct avec la batterie à haute tension (100) avec au moins un groupe de circuits de mesure, au moins un circuit de mesure dudit au moins un groupe de circuits de mesure étant prévu pour mesurer une résistance d'isolement (104) entre un boîtier de batterie à haute tension (103) et au moins une cellule de batterie interne de la batterie à haute tension (100) ;
c) un circuit de mesure (2000) prévu pour contrôler la résistance aux tensions élevées de la batterie à haute tension (100) ;
d) un système de sécurité (300) prévu pour mesurer directement et surveiller la tension des cellules de la batterie à haute tension et le courant, et apte à passer le banc d'essai dans un état de sécurité ;
e) un système de contrôle (400) pourvu d'un système de mesure et de commande et prévu pour rendre disponible la commande séquentielle avec la fonction d'automatisation de test, commander l'unité bidirectionnelle d'alimentation en courant/puits de courant (200), commander le relais présenté dans le montage de mesure (500), mesurer les tensions de mesure et les courants de mesure apparaissant dans le montage de mesure, transmettre des demandes au système de sécurité (300) et fournir une alimentation en basse tension indépendante, isolée de la masse (103) ; et
f) un contrôleur d'isolement (600) prévu pour constater des défauts d'isolement sur le banc d'essai en état de veille et transmettre une indication correspondante au système de sécurité (300).

2. Banc d'essai selon la revendication 1, où une masse (un potentiel de référence) de la batterie à haute tension (100) est séparé d'un conducteur de protection du banc d'essai en mode de contrôle.

3. Banc d'essai selon la revendication 1 ou la revendication 2, où le système de sécurité (300) et / ou le système de contrôle (400) sont galvaniquement séparés du montage de mesure (500).

4. Banc d'essai selon l'une des revendications 1 à 3, où le montage de mesure (500) et / ou au moins un circuit est galvaniquement séparé de l'unité bidirectionnelle d'alimentation en courant/puits de courant (200).

5. Banc d'essai selon l'une des revendications 2 à 4, où le système de sécurité (300) et / ou le système de contrôle (400) sont en contact direct avec le conducteur de protection.

6. Banc d'essai selon l'une des revendications 2 à 5, où, pour mesurer la résistance d'isolement (104) entre le boîtier de batterie à haute tension (103) et ladite au moins une cellule de batterie interne de la batterie à haute tension (100), le circuit de mesure (2000) comprend au moins un amplificateur de mesure isolé du conducteur de protection par un amplificateur d'isolement.

7. Banc d'essai selon l'une des revendications 1 à 6, où, pour mesurer la résistance d'isolement (104) entre le boîtier de batterie à haute tension (103) et ladite au moins une cellule de batterie interne de la batterie à haute tension (100), le circuit de mesure (2000) comprend plusieurs champs de mesure de résistance, lesdits champs de mesure pouvant être commutés automatiquement par au moins un commutateur de champ de mesure.

8. Banc d'essai selon l'une des revendications 1 à 7, où, pour mesurer la résistance d'isolement (104) entre le boîtier de batterie à haute tension (103) et ladite au moins une cellule de batterie interne de la batterie à haute tension (100), le circuit de mesure (2000) comprend au moins un circuit de blocage de niveau, préférentiellement avec au moins une résistance et au moins une paire de diodes Zener.

9. Banc d'essai selon l'une des revendications 1 à 8, où le système de sécurité (300) comprend une commande à programme enregistré.

10. Banc d'essai selon l'une des revendications 1 à 9, où le système de sécurité (300) comprend au moins un contacteur pour la commutation d'au moins un condensateur de circuit intermédiaire, ledit au moins un contacteur étant préférentiellement monté en contact direct avec au moins un contact miroir.

11. Banc d'essai selon l'une des revendications 1 à 10, où le système de contrôle (400) comprend un système de saisie de valeurs de mesure pour la saisie de données des valeurs de mesure générées par ledit au moins un circuit de mesure.

12. Procédé de contrôle et de conditionnement d'une batterie à haute tension (100) sur un banc d'essai selon l'une des revendications précédentes, comprenant les étapes suivantes dans l'ordre suivant :
a) mesure de la résistance d'isolement entre un boîtier de batterie à haute tension (103) et au moins une cellule de batterie interne de la batterie à haute tension (100),
b) mesure d'une tension de batterie,
c) contrôle de l'aptitude au fonctionnement d'au moins un relais se trouvant dans le montage de mesure (500),
d) contrôle d'au moins un blocage électrique,
e) contrôle d'au moins un contrôleur d'isolement (110, 600),
f) mesure de la résistance diélectrique entre chaque pôle (101, 102) de la batterie à haute tension (100) et un boîtier (103) de la batterie à haute tension,
g) mesure du seuil de surcharge de la batterie à haute tension (100),
h) exécution d'un profil de puissance d'impulsion de la batterie à haute tension (100), et
i) conditionnement de la batterie à haute tension (100).

13. Procédé selon la revendication 12, comprenant en outre l'étape suivante :
mesure de la résistance interne d'au moins une cellule de batterie interne de la batterie à haute tension et / ou de la batterie à haute tension.

14. Procédé selon la revendication 12 ou la revendication 13, comprenant en outre l'étape suivante :
mesure de la capacité d'au moins une cellule de batterie interne de la batterie à haute tension et / ou de la batterie à haute tension.
